# EUROPEAN PATENT APPLICATION

(11) **EP 4 704 508 A1**
(43) Date of publication of application: **04.03.2026**
(21) Application number: 25166371.2
(22) Date of filing: 26.03.2025
(51) Int. Cl.: H05K 7/20, G06F 1/20, H01L 23/473

(54) **LIQUID COOLING DEVICE AND WATER COOLING ASSEMBLY**

(30) Priority: 03.09.2024 TW 113209541 U
(71) Applicant: Cooler Master Co., Ltd., Taipei City 114065 (TW)
(72) Inventor: CHEN, WEN-PING, 114065 Taipei City (TW); YI-CHING, LIN, 114065 Taipei City (TW)
(74) Representative: Grünecker Patent- und Rechtsanwälte PartG mbB

(57) **Abstract**

A water cooling assembly for pump installation includes a base having a heat exchange chamber, a plurality of fins positioned in the heat exchange chamber, and a cover member covering the heat exchange chamber. The cover member includes an upper surface and a lower surface opposite to each other. At least one first inlet and at least one first outlet extends through both the upper surface and the lower surface to communicate with the heat exchange chamber fluidly. A cover member channel is formed on the upper surface without penetrating the lower surface, the cover member being in fluid communication with the first outlet.

## Description

### TECHNICAL FIELD

The present disclosure relates to a liquid cooling device and water cooling assembly, particularly to a liquid cooling device and water cooling assembly with cover member channel.

### BACKGROUND

With the rapid development of technology, the computational performance of various electronic components has significantly improved, resulting in increased heat generation. To protect these components from high temperatures, heat dissipation devices must be installed to manage excess heat. For example, liquid cooling systems can be classified into two main types: all-in-one (AIO) liquid cooling devices and modular liquid cooling systems. AIO devices are pre-assembled, while modular systems include multiple components that require assembly by the consumer.

In traditional liquid cooling systems, the positions of the inlet and outlet ports on the cooling plate can be arranged freely. However, in AIO liquid cooling devices, due to the presence of the pump, the positions of the inlet and outlet ports on the water cooling plate are restricted by the necessity to correspond with the positions of the inlet and outlet of the pump. Additionally, as the heat generated by electronic components has increased significantly due to improved computational performance, it is necessary to increase the pressure of the cooling liquid to accelerate the cooling cycle, preventing the evaporation of the liquid.

Generally, manufacturers place a silicone cover member on the top cover of the water cooling plate to guide the cooling liquid flow between the pump and the water cooling plate. However, the silicone cover member in current AIO liquid cooling devices cannot withstand the increased pressure of the cooling liquid and is prone to deformation or damage, resulting in the failure of a cooling cycle. Therefore, one of the challenges that R&D seeks to address is maintaining the efficacy of guiding the cooling liquid flow while simultaneously augmenting the structural integrity of the liquid cooling device to prevent a reduction in cooling efficiency.

### SUMMARY

The invention is as as defined in the appended claims. The present disclosure provides a liquid cooling device and water cooling assembly that effectively guides the flow of cooling liquid while improving the structural strength of the liquid cooling device, thereby maintaining optimal cooling efficiency.

One aspect of the present disclosure provides a liquid cooling device. The liquid cooling device comprises a water cooling assembly including a base having a heat exchange chamber, a plurality of fins being positioned in the heat exchange chamber, and a cover member covering the heat exchange chamber, the cover member having an upper surface and a lower surface opposite to each other, at least one first inlet and at least one first outlet extending through both the upper surface and the lower surface to communicate with the heat exchange chamber fluidly, and a cover member channel being formed on the upper surface without penetrating through the lower surface, where the cover member communications with the first outlet fluidly, and a pump that is mounted on the upper surface of the cover member, the pump having a second inlet and a second outlet, wherein the second inlet is connected to the cover member channel, and the second outlet is connected to the first inlet.

In one embodiment of the present disclosure, the fin has a first end and a second end, the first end being coupled to the base and the second end being coupled to the cover member.

In one embodiment of the present disclosure, the cover member comprises one first inlet and two first outlets, the first inlet being positioned between the two first outlets and connected to the second outlet of the pump, and the cover member channel having two branch channels and a collection channel, a first end of each branch channel being connected to a corresponding first outlet, the second ends of the branch channels being merged into the collection channel, and the collection channel being connected to the second inlet of the pump.

In one embodiment of the present disclosure, the extending direction of the first inlet is parallel to the extending direction of the two first outlets along the length of the cover member plate and perpendicular to the extending direction of the fins.

In one embodiment of the present disclosure, the extending direction of the first inlet is not parallel to the extending direction of the two first outlets along the length of the cover member plate and not perpendicular to the extending direction of each of the fins.

In one embodiment of the present disclosure, the base further includes a thermally conductive bottom plate and an annular side plate, together defining the heat exchange chamber, the annular side plate surrounding the thermally conductive bottom plate, and the cover member plate being positioned between the thermally conductive bottom plate and the pump.

In one embodiment of the present disclosure, the annular side plate has a first connecting portion that is positioned opposite the bottom plate.

In one embodiment of the present disclosure, the cover member has a second connecting portion that is joined to the first connecting portion.

In one embodiment of the present disclosure, the first connecting portion and the second connecting portion are joined by welding.

In one embodiment of the present disclosure, the fins are coupled to the cover member by welding.

Another aspect of the present disclosure provides a water cooling assembly for pump installation. The water cooling assembly includes a base having a heat exchange chamber, a plurality of fins positioned in the heat exchange chamber, and a cover member covering the heat exchange chamber, wherein the cover member includes an upper surface and a lower surface opposite to each other, at least one first inlet and at least one first outlet extends through both the upper surface and the lower surface to communicate with the heat exchange chamber fluidly, and a cover member channel is formed on the upper surface without penetrating the lower surface, the cover member being in fluid communication with the first outlet.

### BRIEF DESCRIPTION OF THE DRAWINGS

Aspects of the present disclosure can be understood from the following detailed description when reading with the accompanying FIGS. It is noted that, in accordance with the standard practice in the industry, various features are not drawn to scale. In fact, the dimensions of the various features may be increased or reduced for clarity of discussion.
FIG. 1 is a perspective view of the liquid cooling device according to one embodiment of the present invention.
FIG. 2 is an exploded view of the liquid cooling device as shown in FIG. 1.
FIG. 3 is a top view showing the alignment of the pump with the base and cover member in the liquid cooling device of FIG. 1.
FIG. 4 is a cross-sectional view of the liquid cooling device, omitting the pump, taken along section line 4-4 of FIG. 3.
FIG. 5 is a cross-sectional view of the liquid cooling device taken along section line 5-5 of FIG. 3.
FIG. 6 is a top view of the heat-conducting base plate and fins of the liquid cooling device in FIG. 1.
FIG. 7 is a cross-sectional view of the liquid cooling device taken along section line 7-7 of FIG. 3.
FIG. 8 is a top view showing the alignment of the pump with the base and cover member in the liquid cooling device of FIG.1.
FIG. 9 is a cross-sectional view of the liquid cooling device taken along section line 9-9 of FIG. 8.

### DETAILED DESCRIPTION

Detailed descriptions and technical contents of the present invention are illustrated below in conjunction with the accompanying drawings. However, it is to be understood that the descriptions and the accompanying drawings disclosed herein are merely illustrative and exemplary and not intended to limit the scope of the present invention.

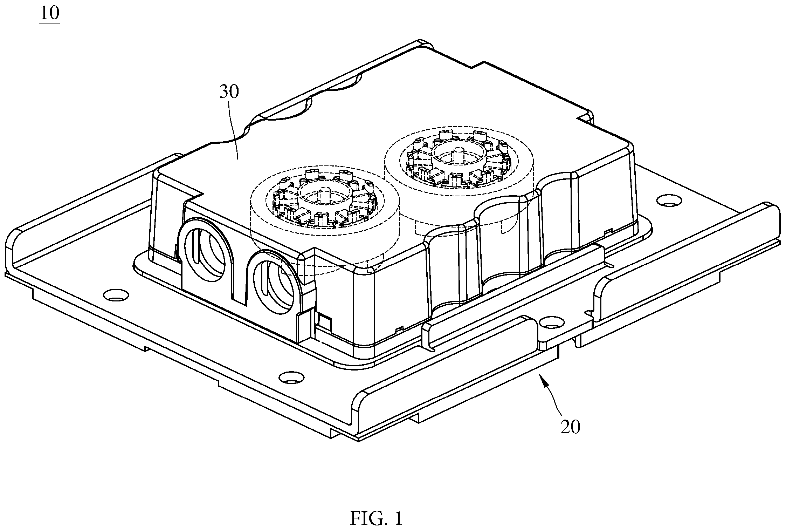

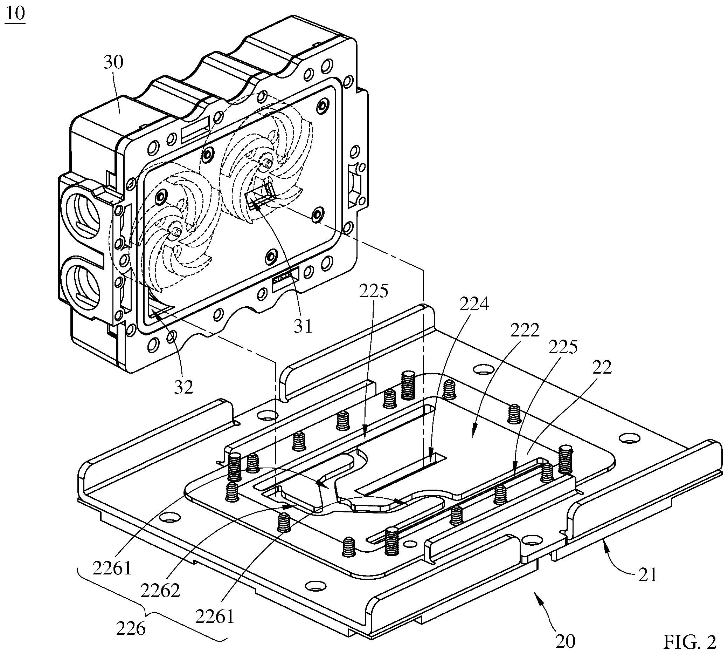

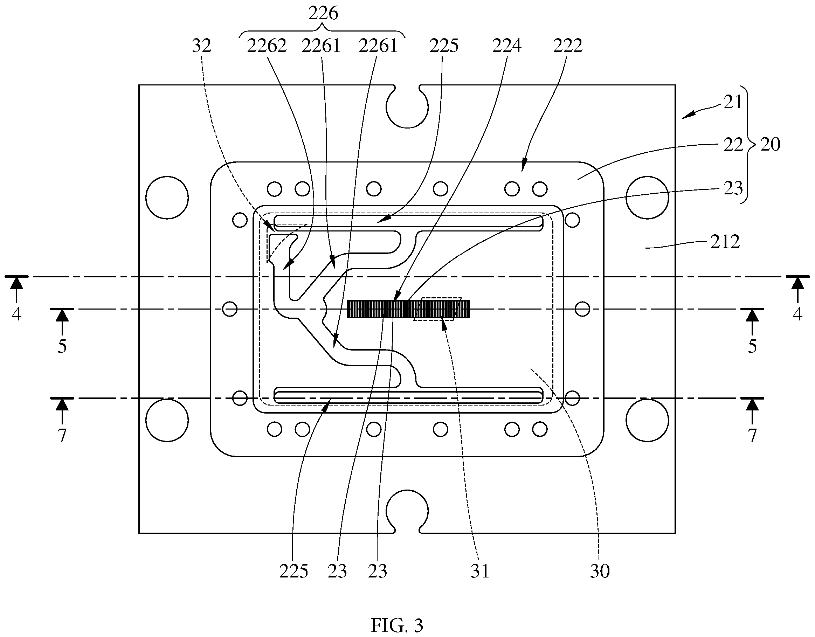

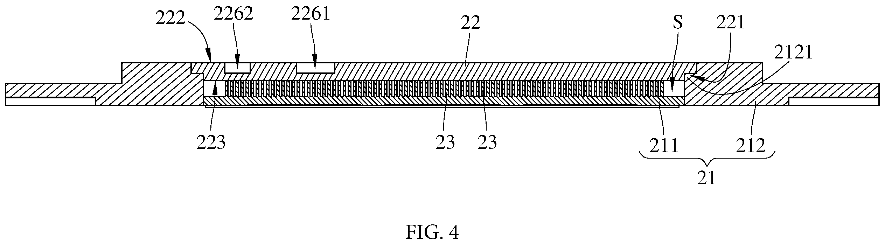

Referring to FIGS. 1 to 4. FIG. 1 is a perspective view of the liquid cooling device according to one embodiment of the present invention. FIG. 2 shows an exploded view of the liquid cooling device shown in FIG. 1. FIG. 3 illustrates a top view showing the alignment of the pump with the base and cover member in the liquid cooling device of FIG. 1. Figure 4 is a cross-sectional view, taken along section line 4-4 of Figure 3, of the liquid cooling device with the pump omitted for clarity.

In one embodiment, the liquid cooling device 10 is, for example, an all-in-one (AIO) liquid cooling device. The so-called AIO liquid cooling device refers to a completed liquid cooling device that integrates components such as a water cooling radiator, a fan, a pump, and a water cooling head. The liquid cooling device 10 contains a cooling fluid (not shown) and is thermally coupled to a heat source (not shown). The cooling fluid may be water or a refrigerant. Further, the liquid cooling device 10 includes a pump 30 and a water cooling assembly 20 with a base 21, a cover member 22, and multiple fins 23.

The base 21 includes a thermally conductive bottom plate 211 that is thermally coupled to the heat source, and an annular side plate 212 that surrounds the bottom plate 211. The bottom plate 211 and the annular side plate 212 together define a heat exchange chamber S. The annular side plate 212 has a first connecting portion 2121, such as a connecting protrusion, positioned opposite the bottom plate 211.

The cover member 22 covers the heat exchange chamber S and has a second connecting portion 221, such as a connecting recess. The first connecting portion 2121 and the second connecting portion 221 are joined and interlocked by welding, for example. The cover member 22 includes an upper surface 222, a lower surface 223, a first inlet 224, two first outlets 225, and a cover member channel 226. The upper surface 222 and lower surface 223 are opposite each other, with the lower surface 223 facing the heat exchange chamber S. The first inlet 224 and the two first outlets 225 pass through both the upper surface 222 and lower surface 223, connecting to the heat exchange chamber S. The first inlet 224 is located between the two first liquid outlets 225. In one embodiment, the extending direction of the first inlet 224 and the extending direction of the two first liquid outlets 225 are, for example, parallel to the extending direction of the long side of the cover member 22. However, the embodiment is not limited thereto. In another embodiment, the extending direction of at least one of the first inlet and the two first liquid outlets is, for example, not parallel to the extending direction of the long side of the cover member.

The cover member channel 226 is positioned on the upper surface 222 of the cover member 22 and does not penetrate to the lower surface 223 of the cover member 22. The cover member channel 226 includes two branch channels 2261 and a collection channel 2262. Each branch channel 2261 has a first end and a second end. The first end connects to a corresponding first outlet 225, while the second ends merging into the collection channel 2262. Therefore, after the cooling fluid exits the first outlets 225, it flows through the branch channels 2261 and converges within the collection channel 2262.

The fins 23 are positioned within the heat exchange chamber S and include a first ends and a second ends. The first ends are coupled to the thermally conductive bottom plate 211, while the second ends of the fins 23 are coupled to the cover member 22, providing structural support. This configuration enables the heat from the heat source to transfer through the bottom plate 211 to the fins 23, allowing the cooling fluid to absorb the heat when it flows over them. Further, the configuration increases the structural strength of the liquid cooling device 10. The fins 23 and cover member 22 may also be coupled by welding, for example. In one embodiment, the first inlet 224 and the first outlets 225 extend perpendicularly to the direction in which each fin 23 extends. However, the embodiment is not limited thereto. In another embodiment, at least one of the first inlet and the first outlets does not extend perpendicularly to the direction in which each fin extends.

In one embodiment, after the first ends of the fins 23 are welded to the thermally conductive bottom plate 211, the fins 23 are inverted to weld the second ends of the fins to the cover member 22. However, the embodiment is not limited thereto. In another embodiment, the second ends of the fins 23 are welded to the cover member 22 first, and the fins 23 are inverted to weld the first ends of the fins 23 to the thermally conductive bottom plate 211. The later welding process prevents welding material from seeping into the gaps between the fins 23, ensuring uninterrupted cooling fluid flow.

The pump 30 drives the cooling fluid flow and is installed on the upper surface 222 of the cover member 22 so that the cover member 22 sits between the thermally conductive bottom plate 211 and the pump 30. The pump 30 has a second outlet 31 and a second inlet 32. The first inlet 224 is in fluid communication with the second outlet 31, allowing cooling fluid to flow from the pump 30 through the first inlet 224 and into the heat exchange chamber S. The collection channel 2262 connects to the second inlet 32, enabling the cooling fluid to flow from the heat exchange chamber S, through the first outlets 225, branch channels 2261, collection channel 2262, and finally into the pump 30.

In one embodiment, the cover member 22, with its cover member channel 226, is welded to the base 21. This configuration not only guides the cooling fluid flow between the pump 30 and the heat exchange chamber S but also reinforces the liquid cooling device 10 to withstand the elevated pressure of the cooling liquid, preventing the liquid cooling device 10 from deformation or damage and then maintaining both optimal cooling fluid flow and structural integrity for maximum cooling efficiency.

Further, with both ends of the fins 23 respectively connected to the thermally conductive bottom plate 211 and the cover member 22, the fins 23 support the cover member 22, providing additional structural integrity to the liquid cooling device 10.

In one embodiment, the cover member 22 includes one first inlet 224, two first outlets 225, and two branch channels 2261. However, the embodiment is not limited thereto. In another embodiment, the number of the first inlets can be two or more, and the number of the first outlet can be single or three or more. If the cover member includes only one first outlet, the cover member channel may not need to have branch channels. If the cover member includes three or more first outlets, the number of branch channels may correspond to the number of outlets.

In one embodiment, the first connecting portion 2121 is a protrusion, and the second connecting portion 221 is a recess, fitting together accordingly. However, in another embodiment, this arrangement can be reversed, with the first connecting portion as a recess and the second as a protrusion.

In one embodiment, the cover member 22 includes a second connecting portion 221 connects to the annular side plate 212 via the first connecting portion 2121 and second connecting portion 221. However, in another embodiment, the cover member may directly connect to the annular side plate through the first connecting portion without requiring a second connecting portion.

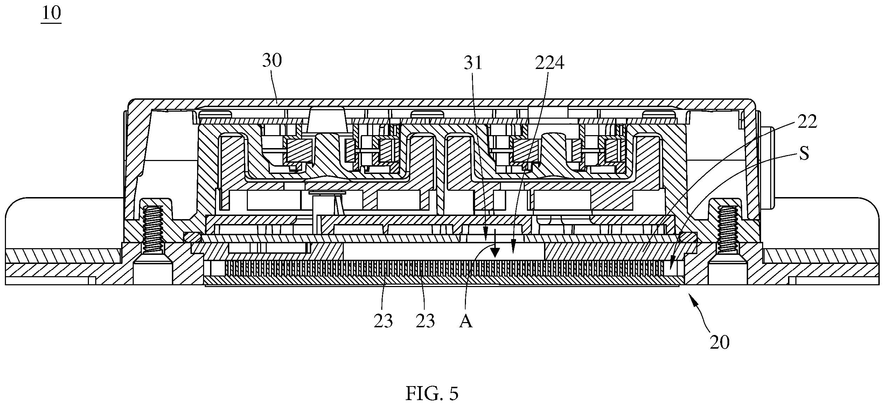

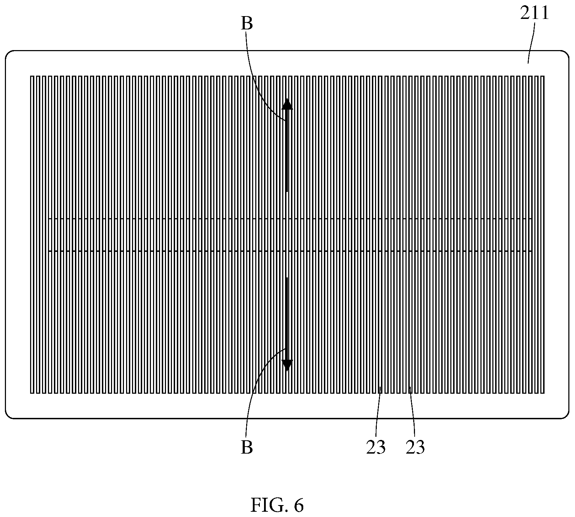

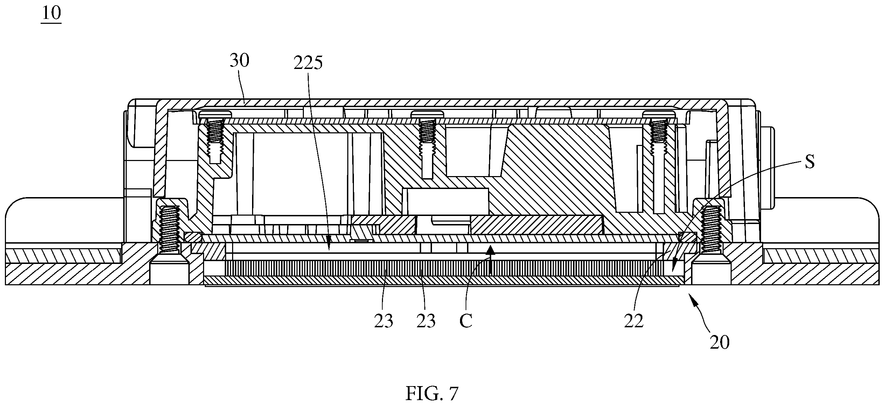

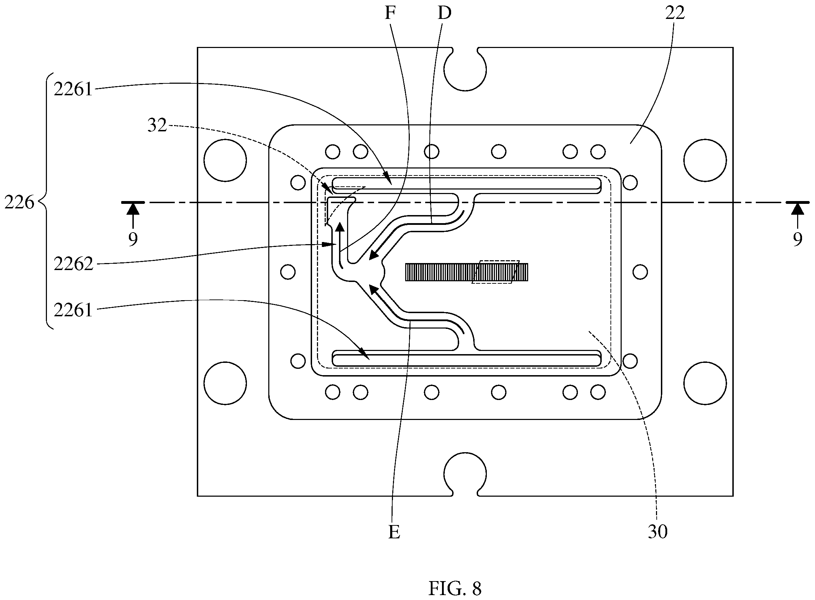

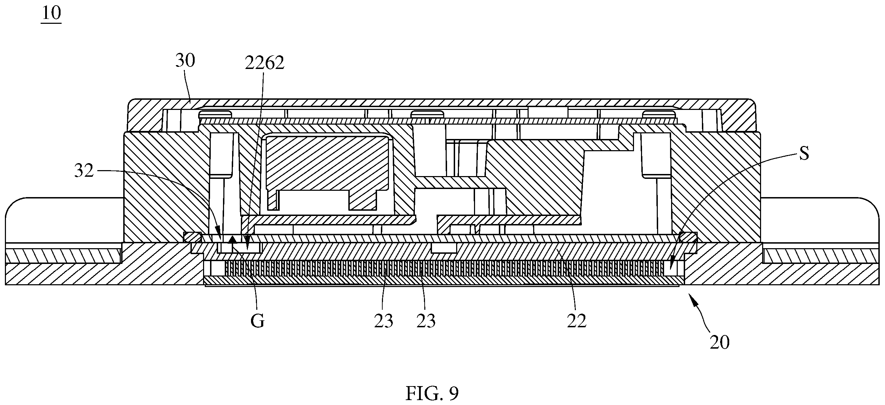

Referring to FIGS. 5 to 9. FIG. 5 illustrates a sectional view along the 5-5 plane of the liquid cooling device depicted in FIG. 3. FIG. 6 shows a top view of the heat-conducting base plate and the fins in the liquid cooling device shown in Figure 1. FIG. 7 provides a sectional view along the 7-7 plane of FIG. 3. FIG. 8 displays a top view of the pump in relation to the base and deflector cover, and FIG. 9 is a sectional view along the 9-9 plane in FIG. 8.

As shown in FIGS. 5 to 6, when cooling fluid enters the pump 30, the pump 30 drives the cooling fluid to exit through the second outlet 31 in the direction of arrow A, the cooling fluid flowing into the heat exchange chamber S through the first inlet 224 of the cover member 22. The cooling fluid then flows through the heat exchange chamber S along the directions of arrows B, passing between the fins 23 to absorb the heat that is transferred to them from the heat source.

Next, as shown in FIGS 7 to 8, the cooling fluid exits the heat exchange chamber S along the direction of arrow C and flows through the two first outlets 225 of the cover member 22, entering the two branch channels 2261. In the branch channels 2261, the cooling fluid flows along the directions of arrows D and E into the collection channel 2262, where it continues to flow along the direction of arrow F. Further, as shown in FIG. 9, the cooling fluid exits the collection channel 2262 along the direction of arrow G, entering pump 30 through second inlet 32. The pump then repeatedly again circulates the cooling fluid back through the system to carry away the heat generated by the heat source, allowing the cooling cycle to repeat.

According to the embodiments above, because the cover member, with its cover member channel, is welded to the base, the liquid cooling device and water cooling assembly can not only guide the cooling fluid flow between the pump and the heat exchange chamber S but also reinforce the liquid cooling device to withstand the elevated pressure of the cooling liquid, preventing the liquid cooling device 10 from deformation or damage and then maintaining both optimal cooling fluid flow and structural integrity for maximum cooling efficiency.

Further, the fins connected on opposite ends to the base and the cover member, providing additional support to the cover member. This additional structural reinforcement enhances the robustness of the liquid cooling device, preserving its quality of performance and durability.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure. Of course, the disclosed embodiments are merely exemplary embodiments and that various modifications can be made without departing from the spirit and scope of the disclosure. Further, it should be understood that various aspects of the embodiment are not mutually exclusive of each other and can be combined as desired by a person of ordinary skill in the art as a matter of design choices.

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. A liquid cooling device (10), comprising:
a water cooling assembly (20) including a base (21) having a heat exchange chamber (S), a plurality of fins (23) being positioned in the heat exchange chamber (S), and a cover member (22) covering the heat exchange chamber (S), the cover member (22) having an upper surface (222) and a lower surface (223) opposite to each other, at least one first inlet (224) and at least one first outlet (225) extending through both the upper surface (222) and the lower surface (223) to communicate with the heat exchange chamber (S) fluidly, and a cover member channel (226) being formed on the upper surface (222) without penetrating through the lower surface (223), where the cover member (22) communications with the first outlet (225) fluidly; and
a pump (30) that is mounted on the upper surface (222) of the cover member (22), the pump (30) having a second inlet (32) and a second outlet (31), wherein the second inlet (32) is connected to the cover member channel (226), and the second outlet (31) is connected to the first inlet (224).

2. The liquid cooling device (10) of claim 1, wherein the fin (23) has a first end and a second end, the first end being coupled to the base (21) and the second end being coupled to the cover member (22).

3. The liquid cooling device (10) of claim 1 or 2, wherein the cover member (22) comprises:
one first inlet (224) and two first outlets (225), the first inlet (224) being positioned between the two first outlets (225) and connected to the second outlet (31) of the pump (30); and
the cover member channel (226) having two branch channels (2261) and a collection channel (2262), a first end of each branch channel (2261) being connected to a corresponding first outlet (225), the second ends of the branch channels (2261) being merged into the collection channel (2262), and the collection channel (2262) being connected to the second inlet (32) of the pump (30).

4. The liquid cooling device (10) of claim 3, wherein the extending direction of the first inlet (224) is parallel to the extending direction of the two first outlets (225) along the length of the cover member plate (22) and perpendicular to the extending direction of the fins (23).

5. The liquid cooling device (10) of claim 3, wherein the extending direction of the first inlet (224) is not parallel to the extending direction of the two first outlets (225) along the length of the cover member plate (22) and not perpendicular to the extending direction of each of the fins (23).

6. The liquid cooling device (10) of one of claims 1 to 5, wherein the base (21) further includes a thermally conductive bottom plate (211) and an annular side plate (212), together defining the heat exchange chamber (S), the annular side plate (212) surrounding the thermally conductive bottom plate (211), and the cover member plate (22) being positioned between the thermally conductive bottom plate (211) and the pump (30).

7. The liquid cooling device (10) of claim 6, wherein the annular side plate (212) has a first connecting portion (2121) that is positioned opposite the bottom plate (211).

8. The liquid cooling device (10) of claim 7, wherein the cover member (22) has a second connecting portion (221) that is joined to the first connecting portion (2121).

9. The liquid cooling device (10) of claim 8, wherein the first connecting portion (2121) and the second connecting portion (221) are joined by welding.

10. The liquid cooling device (10) of one of claim 1 to 9, wherein the fins (23) are coupled to the cover member (22) by welding.

11. A water cooling assembly (20) for pump installation, comprising:
a base (21) having a heat exchange chamber (S);
a plurality of fins (23) positioned in the heat exchange chamber (S); and
a cover member (22) covering the heat exchange chamber (S), wherein
the cover member (22) includes an upper surface (222) and a lower surface (223) opposite to each other,
at least one first inlet (224) and at least one first outlet (225) extends through both the upper surface (222) and the lower surface (223) to communicate with the heat exchange chamber (S) fluidly, and
a cover member channel (226) is formed on the upper surface (222) without penetrating the lower surface (223), the cover member (22) being in fluid communication with the first outlet (225).

12. The water cooling assembly (20) of claim 11, wherein the fin (23) has a first end and a second end, the first end being coupled to the base (21) and the second end being coupled to the cover member (22).

13. The water cooling assembly (20) of claim 11 or 12, wherein the cover member (22) comprises:
one first inlet (224) and two first outlets (225), the first inlet (224) being positioned between the two first outlets (225) and connected to the second outlet (31) of the pump (30); and
the cover member channel (226) having two branch channels (2261) and a collection channel (2262), a first end of each branch channel (2261) being connected to a corresponding first outlet (225), the second ends of the branch channels (2261) being merged into the collection channel (2262), and the collection channel (2262) being connected to the second inlet (32) of the pump (30).

14. The water cooling assembly (20) of claim 13, wherein the extending direction of the first inlet (224) is parallel to the extending direction of the two first outlets (225) along the length of the cover member (22) and perpendicular to the extending direction of each of the fins (23).

15. The water cooling assembly (20) of claim 13, wherein the extending direction of the first inlet (224) is not parallel to the extending direction of the two first outlets (225) along the length of the cover member (22) and not perpendicular to the extending direction of each of the fins (23).

16. The water cooling assembly (20) of one of claims 11 to 15, wherein the base (21) further includes a thermally conductive bottom plate (211) and an annular side plate (212), together defining the heat exchange chamber (S), the annular side plate (212) surrounding the thermally conductive bottom plate (211), and the cover member (22) being positioned between the thermally conductive bottom plate (211) and the pump (30).

17. The water cooling assembly (20) of claim 16, wherein the annular side plate (212) has a first connecting portion (2121) that is positioned opposite the bottom plate (211).

18. The water cooling assembly (20) of claim 17, wherein the cover member plate (22) has a second connecting portion (221) that is joined to the first connecting portion (2121).

19. The water cooling assembly (20) of claim 18, wherein the first connecting portion (2121) and the second connecting portion (221) are joined by welding.

20. The water cooling assembly (20) of one of claims 11 to 19, wherein the fins (23) are coupled to the flow guide cover plate (22) by welding.
